# EUROPÄISCHE PATENTSCHRIFT

(11) **EP 3 166 373 B1**
(45) Veröffentlichungstag und Bekanntmachung des Hinweises auf die Patenterteilung: **09.01.2019**
(21) Anmeldenummer: 15193045.0
(22) Anmeldetag: 04.11.2015
(51) Int. Cl.: H05K 7/14, H02B 1/052, H01R 9/26

(54) **KLEMMMODUL ZUR BEFESTIGUNG AN EINER TRAGSCHIENE**
CLAMP MODULE FOR ATTACHMENT TO A SUPPORTING RAIL
MODULE DE SERRAGE DESTINE A ETRE FIXE SUR UN RAIL SUPPORT

(43) Veröffentlichungstag der Anmeldung: 10.05.2017
(73) Patentinhaber: Selectron Systems AG, 3250 Lyss (CH)
(72) Erfinder: Wälti, Christian, 3273 Kappelen (CH)
(74) Vertreter: Prüfer & Partner mbB Patentanwälte · Rechtsanwälte

(56) Entgegenhaltungen:
- EP-A1- 0 740 499
- EP-A1- 0 818 062
- EP-A1- 2 887 471

## Beschreibung

Die vorliegende Erfindung betrifft ein Klemmmodul zur Befestigung an einer Tragschiene, mit einem Gehäuse, einer Verspanneinrichtung und wenigstens einer daran angeordneten Haltekralle, wobei die Haltekralle mittels der Verspanneinrichtung in eine Befestigungsposition an der Tragschiene bringbar und dort verspannbar ist, um das Klemmmodul lösbar an der Tragschiene zu befestigen.

Ein Klemmmodul zur Befestigung an einer Tragschiene ist beispielsweise aus DE 20 011 105 337 U1 bekannt. Tragschienen werden in der Elektrotechnik insbesondere zur Befestigung von Bauteilen in Verteilerkästen, Schaltschränken, Anschlusskästen und dergleichen verwendet. Dabei werden verschiedene Elektromodule seitlich auf eine Tragschiene aufgeschoben oder von vorne aufgesteckt und mittels insbesondere seitlich daran angeordneten Klemmmodulen gegen ein Verschieben durch Schock und Vibration gesichert. Tragschienen sind in DIN EN 60715 genormt.

Nachteilig an den bekannten Klemmmodulen zur Befestigung an einer Tragschiene ist, dass diese von vorne auf die Tragschiene aufgesetzt werden, wodurch die dahinterliegende Schiene verdeckt wird. So kann ein Monteur nicht genau erkennen, ob das Klemmmodul, wie es zur Befestigung des Klemmmoduls erforderlich ist, bündig auf der Tragschiene aufliegt. Erst nach einer Betätigung der Befestigungseinrichtung des Klemmmoduls zeigt sich, ob das Klemmmodul fest mit der Tragschiene verbunden ist, oder wegen fehlerhaften Aufsetzens des Klemmmoduls auf die Tragschiene keine Verriegelung des Klemmmoduls an der Tragschiene erfolgt ist. In einem solchen Fall löst der Monteur die Befestigungseinrichtung wieder, um das Klemmmodul vor der erneuten Betätigung der Befestigungseinrichtung korrekt auf die Tragschiene aufzusetzen. Durch die fehlende Unterstützung des Monteurs, das korrekte Aufsetzen des Klemmmoduls auf die Tragschiene vor Betätigung der Befestigungseinrichtung zu erkennen, entsteht ein erhöhter Aufwand bei der Montage bekannter Klemmmodule.

EP 0 740 499 A1 offenbart ein Klemmmodul zur Befestigung an einer Tragschiene, mit einem Gehäuse und einem formschlüssigen Schnappverschluss einschließlich einer Haltekralle, die durch den Schnappverschluss in eine Befestigungsposition an der Tragschiene bringbar ist und dort formschlüssig eingreift, um das Klemmmodul lösbar an der Tragschiene zu befestigen.
Der Erfindung liegt daher die Aufgabe zugrunde, ein verbessertes Klemmmodul zur Verfügung zu stellen, bei welchem die korrekte Anordnung des Klemmmoduls an der Tragschiene bei der Montagebeschleunigt werden kann.
Zur Lösung dieser Aufgabe wird ein Klemmmodul zum Befestigen an einer Tragschiene vorgeschlagen, welches ein Gehäuse, eine Verspanneinrichtung und wenigstens eine daran angeordnete Haltekralle aufweist. Die wenigstens eine Haltekralle ist mittels der Verspanneinrichtung in eine Befestigungsposition an der Tragschiene bringbar und dort verspannbar, um das Klemmmodul lösbar an der Tragschiene zu befestigen. Erfindungsgemäß weist das Klemmmodul eine Signaleinrichtung auf, mit wenigstens einem im Gehäuse angeordneten und durch ein Federelement vorgespannten Signalelement, welches durch ein Aufsetzen des Klemmmoduls auf eine Tragschiene entlang einer vorbestimmten Bewegungsbahn entgegen einer Kraft des Federelements bewegbar ist. Durch die Position des Signalelements auf der Bewegungsbahn ist von außerhalb des Gehäuses vor der Befestigung des Klemmmoduls an der Tragschiene erkennbar, ob das Klemmmodul korrekt an der Tragschiene angeordnet ist. Durch die vorgeschlagene Lösung wird dem Monteur ermöglicht, vor der Befestigung eines Klemmmoduls an der Tragschiene zu erkennen, ob das Klemmmodul korrekt an der Tragschiene angeordnet ist. Bereits vor einer Betätigung der Befestigungseinrichtung (Verspanneinrichtung) des Klemmmoduls ist es dadurch möglich, mithilfe der Signaleinrichtung zu erkennen, ob das Klemmmodul korrekt an der Tragschiene angeordnet ist, um die Position des Klemmmoduls gegebenenfalls zu verändern, bevor das Klemmmodul an der Tragschiene befestigt wird. Auf diese Weise kann vermieden werden, dass der Monteur das Klemmmodul aufgrund einer zunächst unkorrekten Anordnung an der Tragschiene unzureichend befestigt, dieses wieder lösen und danach eine erneute Befestigung des Klemmmoduls an der Tragschiene vornehmen muss. Obwohl auch hier die hinter dem Klemmmodul liegende Schiene verdeckt wird, kann der Monteur durch die Signaleinrichtung die korrekte Anordnung des Klemmmoduls erkennen, weshalb die vorgeschlagene Lösung eine senkrechte Montage der Klemmmodule auf die Tragschiene erlaubt. So kann bei der Montage von Klemmmodulen an Tragschienen Zeit und dadurch Kosten eingespart werden.

Das Klemmmodul weist ein Gehäuse sowie eine vorzugsweise wenigstens zum Teil innerhalb des Gehäuses angeordnete Verspanneinrichtung auf. An der Verspanneinrichtung ist wenigstens eine Haltekralle angeordnet, welche mit der Verspanneinrichtung in eine Befestigungsposition an der Tragschiene bringbar und dort verspannbar ist. Bei häufig verwendeten Tragschienen, die beispielsweise die Form eines Hutprofils aufweisen, sind üblicherweise zwei Halteflansche vorgesehen, mittels welcher eine Befestigung von Modulen an den Tragschienen erfolgt. Abhängig von der Ausführungsform von Tragschiene und Klemmmodul weist ein solches Klemmmodul daher üblicherweise wenigstens zwei Haltekrallen auf, mittels welcher dieses an einer Tragschiene befestigbar ist. Dabei ist wenigstens eine Haltekralle an einer Verspanneinrichtung angeordnet, welche das Klemmmodul an der Tragschiene befestigt, insbesondere an dieser verspannt. Weitere Haltekrallen können auch fest am Klemmmodul angeordnet sein, und als statische Halteeinrichtungen wie beispielsweise in Form von Widerlagern zur Befestigung des Klemmmoduls an einer Tragschiene beitragen. Bei anderen Ausführungsformen sind zwei oder mehr Haltekrallen mit der Verspanneinrichtung verbunden und mittels dieser in eine Befestigungsposition an einer Tragschiene bringbar.

Beim erfindungsgemäßen Klemmmodul wird wenigstens eine Haltekralle mittels der Verspanneinrichtung in eine Befestigungsposition an einer Tragschiene gebracht, was beispielsweise mittels einer Verschwenkung und/ oder einer Verschiebung von wenigstens einer Haltekralle erfolgen kann, um das Klemmmodul lösbar an der Tragschiene zu befestigen. Für Ausführungsformen an Tragschienen mit mehreren Befestigungspunkten ist es selbstverständlich im Rahmen der Erfindung möglich, am Klemmmodul mehrere Haltekrallen anzuordnen, wie beispielsweise 2, 3, 4, 5, oder 6 oder sogar mehr Haltekrallen, wobei diese auch parallel nebeneinander zur Befestigung an derselben Befestigungsposition der Tragschiene anordenbar sind. Es ist ebenfalls möglich, nur eine Haltekralle beweglich auszubilden, so dass diese mittels der Verspanneinrichtung in eine Befestigungsposition an der Tragschiene bringbar ist, nachdem eine zweite insbesondere fest angeordnete Haltekralle beim Aufsetzen des Klemmmoduls in eine Befestigungsposition gebracht und durch das Verspannen wenigstens einer zweiten Haltekralle an der Tragschiene befestigt wird.

Das wenigstens eine im Gehäuse angeordnete Signalelement ist insbesondere durch ein Aufsetzen des Klemmmoduls auf eine Tragschiene entlang einer vorbestimmten Bewegungsbahn bewegbar. Das Signalelement ist insbesondere derart auf der Bewegungsbahn bewegbar, dass sich das Signalelement an einer vorbestimmten, von außerhalb des Gehäuses erkennbaren Position befindet, wenn das Klemmmodul korrekt an der Tragschiene angeordnet ist. Als Signaleinrichtung wird das Signalelement bzw. die Signalelemente mit den damit zusammen wirkenden Einrichtungen zur Anzeige der korrekten Position des Klemmmoduls zur Montage verstanden.

Bei einer Ausführungsform des Klemmmoduls weist die Signaleinrichtung zwei Signalelemente auf. Hierdurch kann die korrekte Anordnung des Klemmmoduls an zwei voneinander verschiedenen Positionen von außerhalb des Gehäuses erkannt werden. Da Klemmmodule zur Befestigung häufig an wenigstens zwei Positionen an einer Tragschiene anliegen, kann mittels zwei Signalelementen die korrekte Position an diesen beiden Stellen geprüft werden. Es ist allerdings ebenfalls möglich, beispielsweise abhängig von der Bauform der Tragschiene sowie der Klemmmodule, mehr als zwei Signalelemente vorzusehen, beispielsweise 3, 4, 5, 6 oder auch mehr Signalelemente.

Bei einer Ausführungsform des Klemmmoduls ist das wenigstens eine Signalelement ein Signalstift. Bei einer Ausführungsform ist dieser in Verbindung mit seiner Bewegungsbahn so ausgebildet, dass ein Ende des Signalstifts an der Oberfläche der Tragschiene anliegt, und das zweite Ende des Signalstifts bei korrekter Anordnung des Klemmmoduls im Wesentlichen in den Bereich der Gehäuseoberfläche ragt. Beispielswiese ist dieser Bereich der Gehäuseoberfläche so ausgebildet, dass das Stiftende zum Beispiel mit der Gehäuseoberfläche oder einem daran angeordneten Element bündig angeordnet ist, um zuverlässig und schnell die korrekte Anordnung des Klemmmoduls an der Tragschiene aufgrund der Position des Endes des Signalstifts zu erkennen. Eine solche Gestaltung ermöglicht eine zuverlässige Funktion sowie ein zuverlässiges Erkennen der korrekten Anordnung des Klemmmoduls an der Tragschiene.

Bei einer Weiterentwicklung des Klemmmoduls weist die Verspanneinrichtung ein Zugelement auf, an welchem wenigstens eine Haltekralle schwenkbar angeordnet ist. Die Verspanneinrichtung ist dabei so ausgebildet, dass die wenigstens eine Haltekralle in eine Befestigungsposition an der Tragschiene schwenkbar ist. Dadurch, dass die wenigstens eine Haltekralle in eine Befestigungsposition schwenkbar ist, vereinfacht sich insbesondere das Aufsetzen des Klemmmoduls auf die Halteschiene. Insbesondere bei Gestaltungen, bei welchen alle Haltekrallen in eine Befestigungsposition schwenkbar sind, muss das Klemmmodul nicht auf die Tragschiene aufgeschwenkt werden.

Bei einer Weiterentwicklung des Klemmmoduls weist die Verspanneinrichtung eine Druckplatte auf, welche an der Tragschiene anliegt, wenn das Klemmmodul korrekt an der Tragschiene angeordnet ist. Die Druckplatte ist dabei entsprechend zur Oberfläche der Tragschiene ausgebildet, an welcher das Klemmmodul befestigt werden soll. Die Druckplatte stellt dabei die Lagerung des Klemmmoduls an der Tragschiene dar.

Bei einer weiteren Ausführungsform des Klemmmoduls ist zu dessen Befestigung an der Tragschiene das Zugelement gegen die Druckplatte vorspannbar. Bei einer Ausführungsform, bei welcher die Druckplatte das Lager und damit ein Verbindungselement des Klemmmoduls mit der Tragschiene darstellt, eignet sich die Druckplatte zum Aufnehmen der Spannkräfte der Verspanneinrichtung.

Bei einer Ausführungsform des Klemmmoduls erfolgt die Verspannung des Zugelements gegen die Druckplatte mittels eines Spannelements, insbesondere einer Anzugschraube. Mittels eines Spannelements wie einer Anzugschraube kann eine kostengünstige und darüber hinaus gut dosierbare Möglichkeit zur Verspannung des Zugelements bereitgestellt werden. Mittels einer Anzugschraube kann beispielsweise eine vorbestimmte Verspannlänge durch eine definierte Bewegung, beispielsweise eine Volldrehung, erreicht werden. Diese löst eine vorbestimmte axiale Verschiebung des Zugelements und damit Verspannung der Haltekrallen aus. Ebenfalls ist es dabei beispielsweise möglich, eine einfach dosierbare Verspannung mittels einer händisch bedienbaren Rändelschraube oder eine kraftintensivere Verspannung mittels eines Werkzeugs, wie beispielsweise eines Schraubendrehers vorzusehen.

Eine Ausführungsform des Klemmmoduls ist zur Befestigung an einer Tragschiene in Form einer Hutschiene geeignet. Eine Hutschiene ist eine zur Montage von Elektromodulen häufig verwendete genormte Tragschiene, welche zwei parallel zur Befestigungsfläche nach außen gerichtete Halteflansche aufweist, an welchen die Haltekrallen eingreifen können.

Bei einer weiteren Ausführungsform sind in dem Gehäuse des Klemmmoduls elektronische Bauelemente angeordnet. Das erfindungsgemäße Klemmmodul kann daher sowohl als Klemmmodul eingesetzt werden, welches keine elektrischen Bauelemente aufweist, und daher lediglich zur insbesondere seitlichen Befestigung von an einer Tragschiene angeordneten Elektromodulen Verwendung findet oder auch als Klemmmodul eingesetzt werden, welches in seinem Gehäuse selbst beispielsweise elektronische Bauteile aufweist.

Die Erfindung betrifft ferner ein Modulsystem, welches mehrere nebeneinander an einer Tragschiene angeordnete Elektromodule aufweist, wobei an wenigstens einer Seite der nebeneinander angeordneten Elektromodule ein Klemmmodul angeordnet ist, welches ein oder mehrere der vorausgehend beschriebenen Merkmale aufweist. Das Modulsystem ermöglicht insbesondere auch einen Abgriff der Normtragschiene bei aufliegenden Modulen.

Weitere Vorteile, Merkmale und Anwendungen der vorliegenden Erfindung gehen aus der folgenden Beschreibung in Verbindung mit den Figuren hervor.
- Fig. 1: zeigt die Bauteile einer beispielhaften Verspanneinrichtung eines beispielhaften erfindungsgemäßen Klemmmoduls;
- Fig. 2: zeigt eine Teilschnittansicht eines beispielhaften erfindungsgemäßen Klemmmoduls mit einer Verspanneinrichtung, welche aus den in Fig. 1 dargestellten Bauteilen aufgebaut ist, vor dem Aufsetzen auf eine Tragschiene;
- Fig. 3: zeigt eine Teilschnittansicht des beispielhaften erfindungsgemäßen Klemmmoduls aus Fig. 2 im befestigten Zustand an der Tragschiene; und
- Fig. 4: zeigt ein beispielhaftes Klemmmodul.

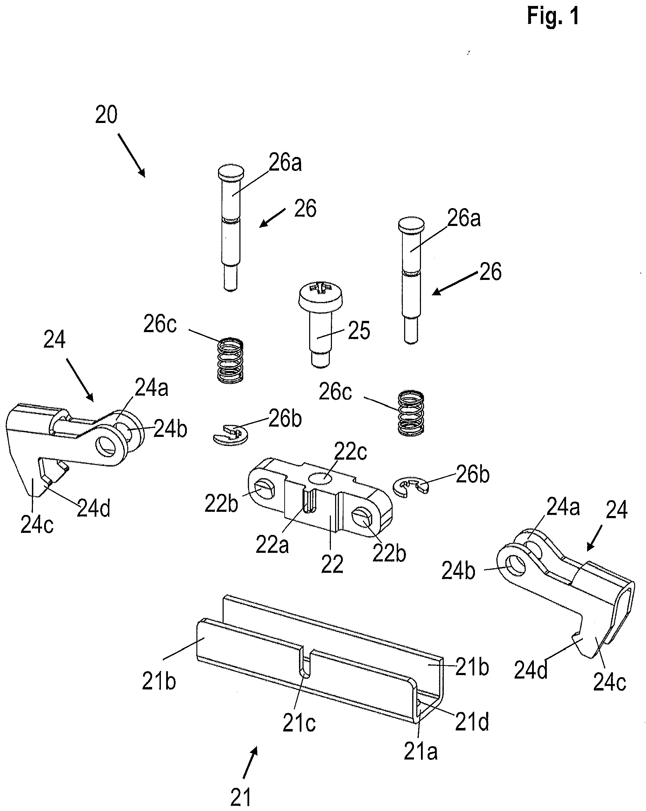

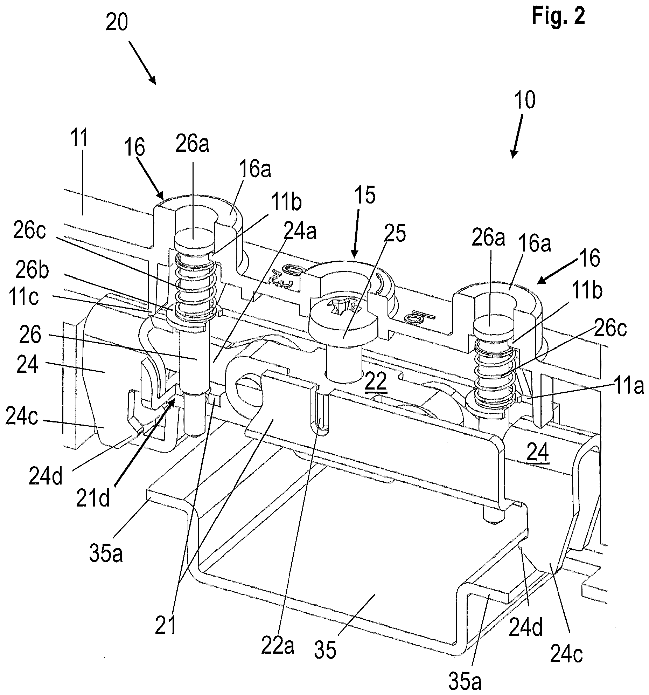

**Fig. 1** zeigt die Bauteile einer beispielhaften Verspanneinrichtung 20 eines beispielhaften erfindungsgemäßen Klemmmoduls 10 (in Fig. 2-4 gezeigt). Die Verspanneinrichtung 20 weist ein Druckblech 21 auf, welches von einer Druckplatte 21a mit zwei daran angeformten Seitenflanschen 21b gebildet wird. Die Druckplatte 21a des Druckblechs 21 ist so ausgebildet, dass diese bei der Montage des Klemmmoduls wenigstens teilweise auf einer Tragschiene aufliegt. In wenigstens einem der Seitenflansche 21b ist eine Führungsnut 21c ausgebildet.

Ein Zugelement, das bei der beispielhaften Ausführungsform als Zugbrücke 22 bezeichnet wird, ist so ausgebildet, dass es innerhalb des Druckblechs 21 anordenbar ist. Diese Zugbrücke 22 weist wenigstens eine Führungsnase 22a auf, die im montierten Zustand der Zugbrücke 22 innerhalb des Druckblechs 21, in der Führungsnut 21c so geführt wird, dass sich die Zugbrücke 22 zwischen den Seitenflanschen 21b senkrecht zur Druckplatte 21a auf diese zu und von dieser weg bewegen kann. An jeder Seite der Zugbrücke 22 ist jeweils an zwei gegenüber liegend angeordneten Vorsprüngen 22b eine Haltekralle 24 schwenkbar anordenbar. Die Vorsprünge 22b sind jeweils im Bereich einer Aussparung an der Zugbrücke 22 ausgebildet.

Im Ausführungsbeispiel sind die Haltekrallen 24 als Blechbiegeteil ausgebildet, so dass an einer Seite der Haltekralle 24 zwei sich gegenüber liegende Haltelaschen 24a mit Haltebohrungen 24b ausgebildet sind, welche passend zu den Vorsprüngen 22b der Zugbrücke 22 angeordnet sind, um die Haltekralle 24 jeweils schwenkbar an der Zugbrücke 22 zu lagern. Am anderen Ende einer Haltekralle 24 sind zwei Krallenelemente 24c ausgebildet, welche zur Verbindung des Klemmmoduls 10 an einer Tragschiene vorgesehen sind. Zum Herstellen einer formschlüssigen Verbindung mit der Tragschiene sind bei der beispielhaften Ausführungsform an den Krallenelementen 24c jeweils Haltevorsprünge 24d ausgebildet.

Zentral in der Zugbrücke 22 und parallel zur Führungsnase 22a ausgerichtet ist eine durchgehende Anzuggewindebohrung 22c angeordnet, in welcher ein Innengewinde ausgebildet ist. Diese Anzuggewindebohrung 22c ist zum Aufnehmen einer Anzugschraube 25 ausgebildet, welche durch Drehen in der Anzuggewindebohrung 22c axial bewegbar ist.

Neben den genannten Elementen weist die Verspanneinrichtung 20 zwei Signalelemente in Form von Signalstiften 26 auf, welche im Bereich der Haltekrallen 24 im Gehäuse 11 des Klemmmoduls 10 anordenbar sind und dort mittels Federelementen 26c und Sicherungsscheiben 26b vorgespannt auf einer Bewegungsbahn bewegbar gehalten sind.

**Fig. 2** zeigt eine Teilschnittansicht eines beispielhaften erfindungsgemäßen Klemmmoduls 10 mit einer Verspanneinrichtung 20, welche aus den in Fig. 1 dargestellten Bauteilen aufgebaut ist, vor dem Aufsetzen auf eine Tragschiene 35. Die beispielhafte Tragschiene 35 ist eine Hutschiene, das heißt eine U-förmige Schiene mit zusätzlich zwei jeweils senkrecht nach außen an den jeweiligen U-Flanschen angeordneten Halteflanschen 35a. Bei der beispielhaften Tragschiene 35 des Ausführungsbeispiels handelt es sich um eine Hutschiene nach EN 50022.

In Fig. 2 ist erkennbar, dass die Zugbrücke 22 innerhalb des Druckblechs 21 angeordnet ist. Die Anzugschraube 25 sitzt bei der dargestellten Position derart innerhalb der Anzuggewindebohrung 22c, dass das Ende der Anzugschraube 25 am Druckblech 21 nicht aus der Zugbrücke 22 hervorragt.

Die Signalstifte 26 sind zwischen den Haltelaschen 24a der Haltekrallen 24 mittels Federelementen 26c und Sicherungsscheiben 26b zwischen jeweils zwei Vorsprüngen 11a und 11b im Gehäuse 11 des Klemmmoduls 10 axial bewegbar angeordnet. Das Federelement 26c bewirkt dabei jeweils eine Vorspannung des jeweiligen Signalstifts 26 in Richtung zum vorgesehenen Montageort an der Tragschiene 35 bzw. zu den Krallenelementen 24c der Haltekrallen 24 hin. Die Bewegungsbahn der Signalstifte 26 entspricht bei dieser beispielhaften Ausführungsform der Längsachse der Signalstifte 26.

An der Außenseite des Gehäuses 11 des Klemmmoduls 10 ist eine Öffnung 15 vorgesehen, durch welche die Anzugschraube 25 zugänglich ist und mittels eines Drehwerkzeugs wie beispielsweise einem Schraubendreher drehbar und damit in axialer Richtung bewegbar ist.

Ferner sind an der Außenseite des Gehäuses 11 des Klemmmoduls 10 zwei Dome 16 ausgebildet, durch welche jeweils die Lage des Kopfs 26a des Signalstifts 26 von außerhalb des Gehäuses 11 des Klemmmoduls 10 erkennbar ist. In Fig. 2 ist das Klemmmodul 11 vor dem Aufsetzen auf eine Tragschiene 35 und damit in einer gelösten Position gezeigt. Die Signalstifte 26 sind in dieser Situation in einer vorgespannten Position, in welcher sie durch jeweils eine in der Druckplatte 21a des Druckblechs 21 angeordnete Drucköffnung 21d ragen. Die Köpfe 26a der Signalstifte 26 sind in dieser Position der Signalstifte 26 auf der Bewegungsbahn innerhalb der Dome 16 von deren oberen Rand 16a nach innen versetzt angeordnet.

Wird das Klemmmodul 10 nun bündig an die Tragschiene 35 bzw. deren Halteflansche 35a gedrückt, setzen die unteren Enden der Signalstifte 26 auf die Tragschiene 35 auf, wodurch sich die Signalstifte 26 entlang ihrer Längsachse, also entlang ihrer Bewegungsbahn entgegen der Kraft des Federelements 26c nach oben schieben. Sind beide Köpfe 26a der Signalstifte 26 bündig mit dem oberen Rand 16a der Dome 16, so signalisiert dies, dass das Klemmmodul 10 korrekt auf der Tragschiene 35 aufliegt. Falls nur ein Kopf 26a bündig mit dem oberen Rand 16a seines Doms 16 ist, zeigt dies, dass das Klemmmodul 10 nicht korrekt in Montageposition auf der Tragschiene 35 angeordnet ist.

Sobald das Klemmmodul 10 so auf der Tragschiene 35 angeordnet ist, dass beide Köpfe 26a der Signalstifte 26 bündig mit dem oberen Rand 16a der beiden Dome 16 angeordnet sind, kann der Anwender bei stetigem Beibehalten der Position des Klemmmoduls 10 mittels Drehen der Anzugschraube 25 in Anziehdrehrichtung die Zugbrücke 22 durch Verspannen der Anzugschraube 25 an der Druckplatte 21a gegenüber dem Druckblech 22 von der Tragschiene 35 weg bewegen. Dabei wandert die Zugbrücke 22 geführt durch die Führungsnase 22a in der Führungsnut 21a im Druckblech 21 der Steigung der Anzugschraube 25 entsprechend bei AnziehDrehrichtung nach oben, da die Anzugschraube 25 durch das Druckblech 21 und das Gehäuse in ihrer Position fixiert ist. Die Haltelaschen 24a der Haltekrallen 24 werden auf diese Weise ebenfalls in Richtung von der Tragschiene 35 weg bewegt.

Durch jeweils einen ebenfalls im Gehäuse 11 des Klemmmoduls 10 angeordneten Niederhalter 11c werden die Haltekrallen 24 mit daran ausgebildeten Haltevorsprüngen 24d so am Gehäuse 11 gelagert, dass diese bei der vorbeschriebenen Bewegung der Zugbrücke 22 vom Druckblech 21 weg, zwangsgeführt unter die Halteflansche 35a der Tragschiene 35 schwenken. Dabei wird die Verspanneinrichtung 20 bzw. das Klemmmodul 10 an der Tragschiene 35 verspannt.

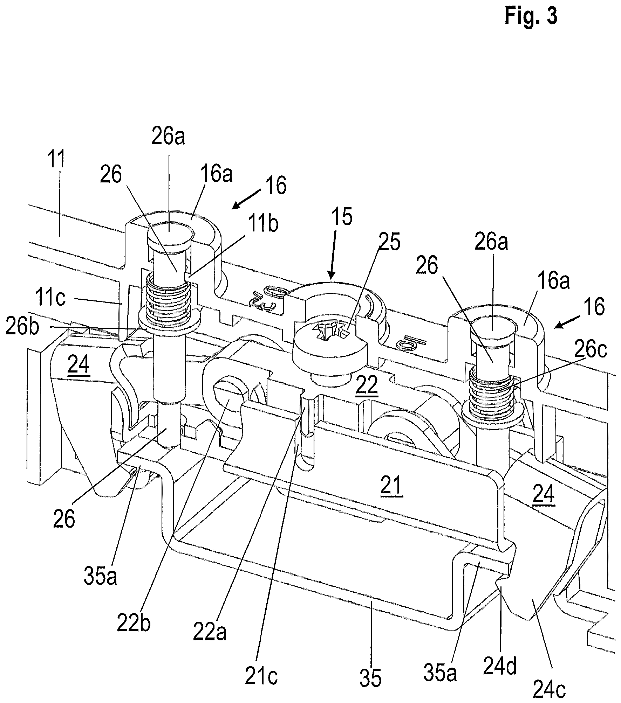

**Fig. 3** zeigt eine Teilschnittansicht des beispielhaften erfindungsgemäßen Klemmmoduls aus Fig. 2 im befestigten Zustand an der Tragschiene. In dieser Abbildung ist gut erkennbar, dass die Köpfe 26a der Signalstifte 26 bündig mit dem jeweils oberen Rand 16a der Dome 16 am Gehäuse 11 positioniert sind, während die Signalstifte 26 auf den Halteflanschen 35a der Tragschiene 35 aufliegen. Ebenfalls gut erkennbar ist, dass die Zugbrücke 22 mittels der Anzugschraube 25 gegenüber dem Druckblech 21 nach oben versetzt verspannt ist, wodurch die Haltekrallen 24 in Verspannungsposition verschwenkt sind, in welcher das Klemmmodul fest mit der Tragschiene 35 verbunden ist.

Die Demontage des Klemmmoduls 10 erfolgt analog der Montage durch Ausführen der beschriebenen Schritte in umgekehrter Reihenfolge. Dabei wird die Zugbrücke 22 mittels eines Drehwerkzeugs durch Drehen der Anzugschraube 25 in Löserichtung gegenüber dem Druckblech 21 gelöst, wodurch die Haltekrallen 24 aus der Verspannposition ausgeschwenkt werden.

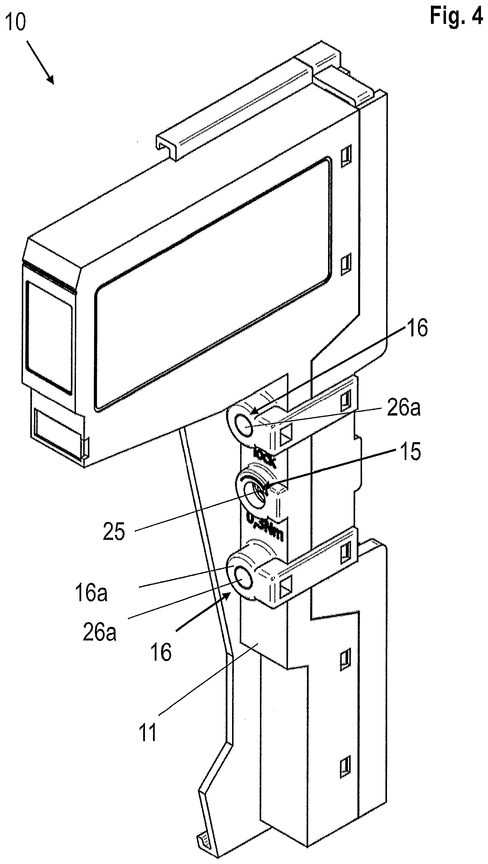

**Fig. 4** zeigt ein beispielhaftes Klemmmodul 10. In dieser Ansicht ist insbesondere die Öffnung 15 dargestellt, durch welche die Anzugschraube 25 zugänglich ist. Ferner sind zwei Dome 16 erkennbar, gegenüber welchen die Signalstifte 26 bewegbar angeordnet sind. Aufgrund der Position des jeweiligen Kopfs 26a eines Signalstifts 26 gegenüber dem oberen Rand 16a des jeweiligen Doms 16 ist eine zur Montage geeignete Anordnung des Klemmmoduls 10 an der Tragschiene 35 erkennbar.

### BEZUGSZEICHENLISTE

- 10: Klemmmodul
- 11: Gehäuse
- 20: Verspanneinrichtung
- 21: Druckblech
- 21a: Druckplatte
- 21b: Seitenflansch
- 21c: Führungsnut
- 21d: Drucköffnung
- 22: Zugbrücke
- 22a: Führungsnase
- 22b: Vorsprung
- 22c: Anzuggewindebohrung
- 24: Haltekralle
- 24a: Haltelasche
- 24b: Haltebohrung
- 24c: Krallenelement
- 24d: Haltevorsprung
- 25: Anzugschraube
- 26: Signalstift
- 26a: Kopf des Signalstifts
- 26b: Sicherungsscheibe
- 26c: Federelement
- 35: Tragschiene
- 35a: Halteflansch

## Patentansprüche

1. Klemmmodul zur Befestigung an einer Tragschiene, aufweisend ein Gehäuse (11), eine Verspanneinrichtung (20) und wenigstens eine an der Verspanneinrichtung (20) angeordnete Haltekralle (24), wobei wenigstens eine Haltekralle (24) mittels der Verspanneinrichtung (20) in eine Befestigungsposition an der Tragschiene (35) bringbar und dort verspannbar ist, um das Klemmmodul (10) lösbar an der Tragschiene (35) zu befestigen,
**gekennzeichnet durch**
eine Signaleinrichtung (16, 26) mit wenigstens einem im Gehäuse (11) angeordneten und durch ein Federelement (26c) vorgespannten Signalelement (26), welches durch ein Aufsetzen des Klemmmoduls (10) auf eine Tragschiene (35) entlang einer vorbestimmten Bewegungsbahn entgegen einer Kraft des Federelements (26c) bewegbar ist, wobei durch die Position des Signalelements (26) auf der Bewegungsbahn von außerhalb des Gehäuses (11) vor der Befestigung des Klemmmoduls (10) an der Tragschiene (35) erkennbar ist, ob das Klemmmodul (10) korrekt an der Tragschiene (35) aufgesetzt ist.

2. Klemmmodul nach Anspruch 1, **dadurch gekennzeichnet, dass** die Signaleinrichtung (16, 26) zwei Signalelemente (26) aufweist, wodurch die korrekte Anordnung des Klemmmoduls (10) an zwei voneinander verschiedenen Positionen von außerhalb des Gehäuses (11) erkennbar ist.

3. Klemmmodul nach einem der vorhergehenden Ansprüche, **dadurch gekennzeichnet, dass** das wenigstens eine Signalelement (26) ein Signalstift (26) ist, von welchem ein Ende im Wesentlichen in den Bereich (16) der Gehäuseoberfläche ragt, wenn das Klemmmodul (10) korrekt an der Tragschiene (35) angeordnet ist.

4. Klemmmodul nach einem der vorhergehenden Ansprüche, **dadurch gekennzeichnet, dass** die Verspanneinrichtung (20) ein Zugelement (22) aufweist, an welchem die wenigstens eine Haltekralle (24) schwenkbar angeordnet ist.

5. Klemmmodul nach Anspruch 4, **dadurch gekennzeichnet, dass** die Verspanneinrichtung (20) eine Druckplatte (21a) aufweist, welche an der Tragschiene (35) anliegt, wenn des Klemmmodul (10) korrekt an der Tragschiene (35) angeordnet ist.

6. Klemmmodul nach Anspruch 5, **dadurch gekennzeichnet, dass** zum Befestigen des Klemmmoduls (10) an der Tragschiene (35) das Zugelement (22) gegen die Druckplatte (21) verspannbar ist, wodurch wenigstens eine Haltekralle (24) an der Tragschiene (35) verspannbar ist.

7. Klemmmodul nach Anspruch 6, **dadurch gekennzeichnet, dass** die Verspannung des Zugelements (22) gegen die Druckplatte (21a) mittels eines Spannelements, insbesondere einer Anzugschraube (25) erfolgt.

8. Klemmmodul nach einem der vorhergehenden Ansprüche, **dadurch gekennzeichnet, dass** die Tragschiene (35) eine Hutschiene ist.

9. Klemmmodul nach einem der vorhergehenden Ansprüche, **dadurch gekennzeichnet, dass** in dem Gehäuse (11) elektronische Bauelemente angeordnet sind.

10. Modulsystem aufweisend mehrere nebeneinander an einer Tragschiene (35) angeordnete Elektromodule, **dadurch gekennzeichnet, dass** an wenigstens einer Seite der nebeneinander angeordneten Elektromodule ein Klemmmodul (10) nach einem der vorhergehenden Ansprüche angeordnet ist.

## Claims

1. Clamping module for securing to a support rail, having a housing (11), a bracing device (20) and at least one retaining claw (24) arranged on the bracing device (20), wherein at least one retaining claw (24) can be moved into a securing position on the support rail (35), and can be braced there, by means of the bracing device (20), in order for the clamping module (10) to be secured in a releasable manner to the support rail (35),
**characterised by**
a signal device (16, 26) with at least one signal element (26), which is arranged in the housing (11) and can be moved against the force of the spring element (26c) along a predetermined movement path by virtue of the clamping module (10) being positioned on a support rail (35), wherein the position of the signal element (26) on the movement path makes it possible to ascertain from outside the housing (11) whether the clamping module (10) is mounted correctly on the support rail (35).

2. Clamping module according to claim 1, **characterised in that** the signal device (16, 26) has two signal elements (26), as a result of which it is possible to ascertain the correct arrangement of the clamping module (10) from outside the housing (11) at two different positions.

3. Clamping module according to any of the preceding claims, **characterised in that** the at least one signal element (26) is a signal pin (26), of which one end projects substantially into the region (16) of the housing surface when the clamping module (10) is arranged correctly on the support rail (35).

4. Clamping module according to any of the preceding claims, **characterised in that** the bracing device (20) has a pulling element (22), on which the at least one retaining claw (24) is arranged in a pivotable manner.

5. Clamping module according to claim 4, **characterised in that** the bracing device (20) has a pressure-exerting plate (21a), which butts against the support rail (35) when the clamping module (10) is arranged correctly on the support rail (35).

6. Clamping module according to claim 5, **characterised in that,** in order to secure the clamping module (10) to the support rail (35), the pulling element (22) can be braced against the pressure-exerting plate (21), as a result of which at least one retaining claw (24) can be braced on the support rail (35).

7. Clamping module according to claim 6, **characterised in that** the pulling element (22) is braced against the pressure-exerting plate (21a) by means of a tensioning element, in particular a tightening screw (25).

8. Clamping module according to any of the preceding claims, **characterised in that** the support rail (35) is a top-hat rail.

9. Clamping module according to any of the preceding claims, **characterised in that** electronic components are arranged in the housing (11).

10. Module system having a plurality of electronic modules arranged one beside the other on a support rail (35), **characterised in that** a clamping module (10) according to any of the preceding claims is arranged on at least one side of the electronic modules arranged one beside the other.

## Revendications

1. Module de serrage à fixer sur un rail support, comportant une enveloppe (11), un dispositif (20) de blocage et au moins un sabot (24) de maintien, monté sur le dispositif (20) de blocage, au moins un sabot (24) de maintien pouvant être mis, au moyen du dispositif (20) de blocage, dans une position de fixation sur le rail (35) support et y être bloqué pour fixer le module (10) de serrage de manière amovible au rail (35) support,
**caractérisé par**
un dispositif (16, 26) de signalisation ayant au moins un élément (26) de signalisation, qui est disposé dans l'enveloppe (11), qui est précontraint par un élément (26c) de ressort et qui peut, par mise du module (10) de serrage sur un rail (35) porteur, être déplacé suivant un trajet de déplacement défini à l'avance à l'encontre d'une force de l'élément (26c) de ressort, dans lequel, par la position de l'élément (26) de signalisation sur le trajet de déplacement, on peut reconnaître, de l'extérieur de l'enveloppe (11), avant de fixer le module (10) de serrage sur le rail (35) de support, si le module (10) de serrage est mis correctement sur le rail (35) de support.

2. Module de serrage suivant la revendication 1, **caractérisé en ce que** le dispositif (16, 26) de signalisation a deux éléments (26) de signalisation, grâce à quoi la mise du module (10) de serrage en deux positions différentes l'une de l'autre peut être reconnue de l'extérieur de l'enveloppe (11).

3. Module de serrage suivant l'une des revendications précédentes, **caractérisé en ce que** le au moins un élément (26) de signalisation est une broche (26) de signalisation, dont une extrémité fait saillie sensiblement dans la région (16) de la surface de l'enveloppe si le module (10) de serrage est mis correctement sur le rail (35) de support.

4. Module de serrage suivant l'une des revendications précédentes, **caractérisé en ce que** le dispositif (20) de blocage a un élément (22) de traction, sur lequel est monté pivotant le au moins un sabot (24) de maintien.

5. Module de serrage suivant la revendication 4, **caractérisé en ce que** le dispositif (20) de blocage a une plaque (21a) de pression, qui s'applique au rail (35) de support si le module (10) de serrage est mis correctement sur le rail (35) de support.

6. Module de serrage suivant la revendication 5, **caractérisé en ce que**, pour fixer le module (10) de serrage sur le rail (35) de support, l'élément (22) de traction peut être bloqué sur la plaque (21) de pression, grâce à quoi un sabot (24) de maintien peut être bloqué sur le rail (35) de support.

7. Module de serrage suivant la revendication 6, **caractérisé en ce que** le blocage de l'élément (22) de traction sur la plaque (21a) de pression s'effectue au moyen d'un élément de blocage, notamment d'une vis (25) de serrage.

8. Module de serrage suivant l'une des revendications précédentes, **caractérisé en ce que** le rail (35) de support est un profilé en chapeau.

9. Module de serrage suivant l'une des revendications précédentes, **caractérisé en ce que** des composants électroniques sont disposés dans l'enveloppe (11).

10. Système de module ayant plusieurs modules électriques, montés les uns à côté des autres sur un rail (35) de support, **caractérisé en ce que**, d'au moins un côté des modules électriques montés les uns à côté des autres, est monté un module (10) de serrage suivant l'une des revendications précédentes.
